# EUROPEAN PATENT APPLICATION

(11) **EP 4 593 286 A1**
(43) Date of publication of application: **30.07.2025**
(21) Application number: 24154423.8
(22) Date of filing: 29.01.2024
(51) Int. Cl.: H03B 9/12

(54) **ELECTRONIC PHASE OSCILLATION-BASED LOGIC DEVICES**

(71) Applicant: Max-Planck-Gesellschaft zur Förderung der Wissenschaften e.V., 80539 München (DE)
(72) Inventor: PARKIN, S. P., Stuart, 06118 Halle (DE); JEON, Jae-Chun, 06108 Halle (DE); LI, Guanmin, 06108 Halle (DE); WANG, Zhong, 06108 Halle (DE)
(74) Representative: Schweitzer, Klaus

(57) **Abstract**

The present invention relates to a thermally coupled correlated oxide oscillator system comprising at least two correlated oxide oscillators coupled via at least one heating element, which is inter-positioned between at least two of the at least two correlated oxide oscillators. The invention further relates to a logic device comprising a multiplicity of coupled correlated oxide oscillator / heating element cells, wherein each cell has a dimension of 1-heat-n-oscillators.

## Description

The present invention relates to linked correlated oxide devices forming building blocks for both Boolean and non-Boolean computation. Particularly, VO₂-based heat-linked phase oscillation devices are described, which create uniquely coupled oscillation states, which in turn can be used as building blocks for logic devices, e.g. in (neural) networks.

Neural networks may enable a wide range of computing tasks, for example, tasks related to artificial intelligence or machine learning. One example of a neural network is an oscillator neural network (ONN). An oscillatory neural network (ONN) is an artificial neural network that uses coupled oscillators as neurons. Oscillatory neural networks are inspired by the phenomenon of neural oscillations in the brain. Oscillatory neural networks have been trained to recognize images. Complex-Valued Oscillatory networks have also been shown to store and retrieve multidimensional aperiodic signals. An oscillatory auto-encoder has also been demonstrated, which uses a combination of oscillators and rate-coded neurons. A neuron made of two coupled oscillators, one having a fixed and the other having a tunable natural frequency, has been shown able to run logic gates such as XOR that conventional sigmoid neurons cannot.

Thus, networks of coupled oscillators provide for highly efficient means of computation.

### Problem

The key to develop such technology is to establish the interaction among the oscillators and the ability to manipulate the coupling effect between neighboring oscillators in an energetically efficient way. Accordingly, critical aspects for the further development of such networks are to find appropriate oscillator systems which are capable to mutually interact with each other and allow for the control of the interactions (coupling strength) between neighboring oscillators for their synchronization.

For generating the oscillation and for tuning the coupling, typically, additional electronic elements are required. This not only increases the complexity for the design of any computational circuit, but also limits the degree of freedom to tune the dynamics of the network during operation. It would, thus, be desirable to provide for Boolean (logic gates) and non-Boolean (analog) computation techniques that do not require or at least require a reduced number of additional electronic elements and which preferably use oscillation states based on both frequency and amplitude. This would allow for richer and tunable coupling dynamics and thus more complex sets of synchronous oscillation states.

### Solution

It is known that certain class of correlated oxide materials in which the phase transition between two distinguishable states is near room temperature can show thermally coupled oscillation behavior. For example, NbO₂ and Ta₂O₅₋ₓ *[*M. D. Pickett and R. S. Williams. Sub-100 fJ and sub-nanosecond thermally driven threshold switching in niobium oxide crosspoint nanodevices. Nanotechnology, 23, 215202 (2012*);* M. D. Pickett, G. Medeiros-Ribeiro, and R. S. Williams. A scalable neuristor built with Mott memristors. Nat. Mat. 12, 114, (2013*); and* A. Sharma, J. A. Bain, and J. A. Weldon. Phase Coupling and Control of Oxide-based Oscillators for Neuromorphic Computing. IEEE Journal on Exploratory Solid-State Computational Devices and Circuits, PP (99):1-1, (2015*)].*

Highly interesting oscillators can be formed from strongly correlated oxide materials that display an insulator to metal transition, e.g. VO₂ [1, 2].

The controlled oscillation between the low (metal) and high resistance (insulator) states in such materials is possible under an external stimulus such as current, magnetic field, or electric field [3, 4]. Oscillators based on vanadium dioxide (VO₂) are of particular interest since the material undergoes an insulating to metallic phase transition near room temperature [5 - 8]. Coupling between the VO₂ oscillators can be controlled either via external electronic components [9 - 13] or by thermal links [14]. Yet, for these thermally coupled oscillators additional capacitor/resistors are needed to induce oscillation. Moreover, the synchronization range between two oscillators cannot be tuned.

So far, computational schemes based on the phase relationship between oscillators has been the most common technique used in coupled VO₂ networks [10 - 12]. These schemes rely on binary logic where the two states correspond to the phase of the oscillator (0° or 180°) relative to a reference oscillator. However, additional electronic elements are required for generating the oscillation and for tuning the coupling among these VO₂ devices.

The present inventors now have found a novel and effective approach to enable thermally coupled correlated oxide oscillator systems which exhibit a tunable synchronized frequency and different collective coupling behavior.

This was achieved by inserting an additional heating element, e.g. a metal wire, like an Fe-, Cu-, Co-, Ni-, W-, V- or a corresponding alloy-wire, preferably a VO₂ nanowire, preferably with a diameter in the 1 to 3 digit nano-range, between two oscillators, which heating element acts as a thermal cell that can actively change the ambient thermal condition between two oscillators. In such a system, the oscillators can effectively be synchronized and triggered even in a sub-threshold current range via active control of the thermal heating element. Different operation modes of the thermal heating element (V-mode I I-mode) enable rich and controllable coupling dynamics among the oscillators in the system. Various oscillation states can be generated by these coupled oscillators to realize multiple different basic Boolean logic operations from AND, NAND and NOR gates in V-mode (thermal heating element). In addition, the thermal heating element can induce cascade synchronization among multiple coupled cells when operated in I-mode - which generates more complex forms of the oscillation states (spiking and bursting patterns) that mimic the behavior of a biological neuron.

### Brief Description of the invention

The present invention, therefore, relates to a thermally coupled correlated oxide oscillator system comprising at least two correlated oxide oscillators coupled via at least one heating element, which is inter-positioned between at least two of the at least two correlated oxide oscillators.

The invention further comprises a logic device comprising a multiplicity of coupled correlated oxide oscillator / heat element cells, wherein each cell has a dimension of 1-heat-n-oscillators, with n= 1, 2, 3, 4, 5, 6, 7, 8; preferably n= 2, 3, 4, 5, 6, 7, 8, more preferred n= 2, 3, 4.

In principle, the number of coupled oscillators can be extended as long as the heat range reaches.

### Brief Description of the Figures

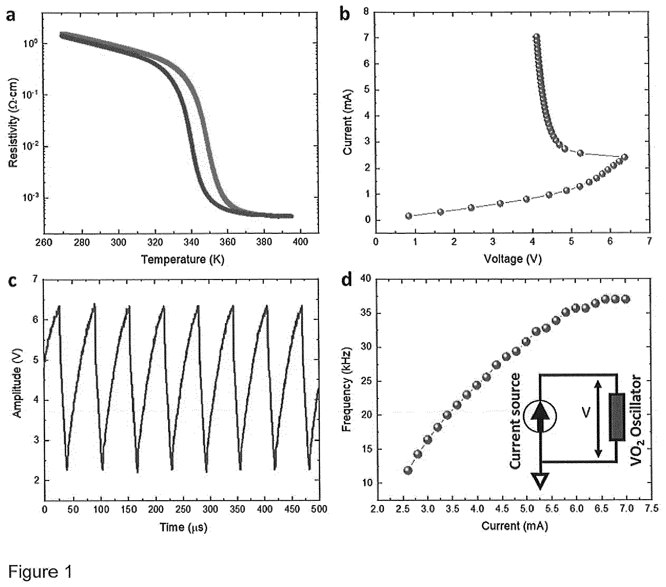

Fig. 1 shows the fundamental transport behavior of a single VO₂ oscillator.
   a: R-T measurement of VO₂ bar shows more than 3 orders of change in resistivity. Red curve corresponds to the warming process (from 270 K to 395 K), while blue curve corresponds to the cooling process (from 395 K to 270 K).
   b: I-V measurement (scan in current from 0 to 8 mA while measuring voltage) of single VO₂ oscillator.
   c: Single VO₂ oscillator shows oscillation in voltage when driven by a constant current source. Here the waveform of oscillating voltage of a single VO₂ oscillator when supplied with 3 mA current is demonstrated.
   d: Oscillation frequency increases with linearly increasing current value within the negative differential resistance region.

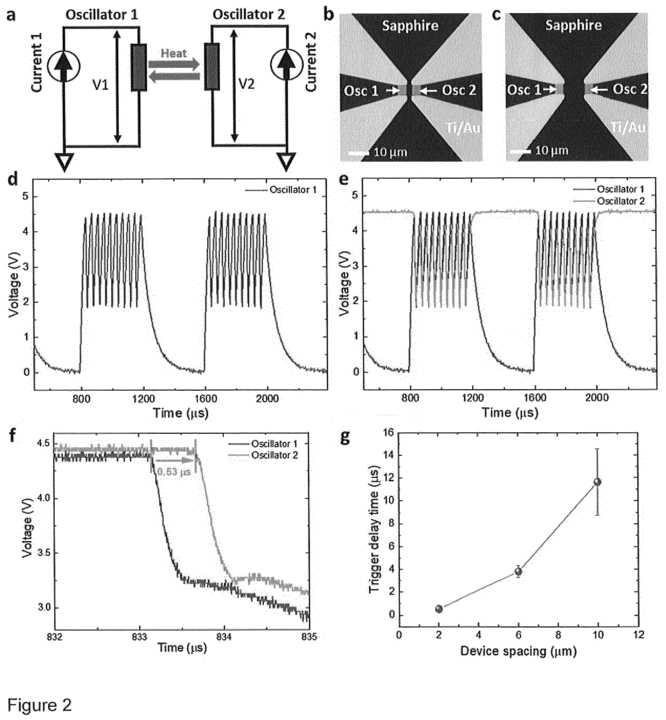

Fig. 2 shows the direct electrical observation of trigger time between two coupled VO₂ oscillators.
   a: Schematic illustration of two thermally coupled VO₂ oscillators. Oscillator 1 (5×5 µm²) and oscillator 2 (5x5 µm²) separated by 2 µm (Fig. 2b) and 10 µm (Fig. 2c).
   d: The phase oscillation when 400 µs (pulse period of 800 µs) is sent to oscillator 1.
   e: Coupled oscillation behavior between Oscillator 1 and Oscillator 2. In this experiment, Oscillator 2 is excited by a constant current of 2.3 mA that is lower than the oscillation threshold current. Note that the threshold current is 2.5 mA. When Oscillator 1 is activated to the oscillation state by current pulse (2.8 mA - 400 µs), Oscillator 2 starts to oscillate with the same frequency.
   f: Direct observation of the trigger delay between two VO₂ oscillators with 2 µm spacing - it takes about 0.53 µs for triggering Oscillator 2 into the oscillation state.
   g: Trigger delay time of two VO₂ oscillators with different spacing (2 µm, 6 µm, and 10 µm).

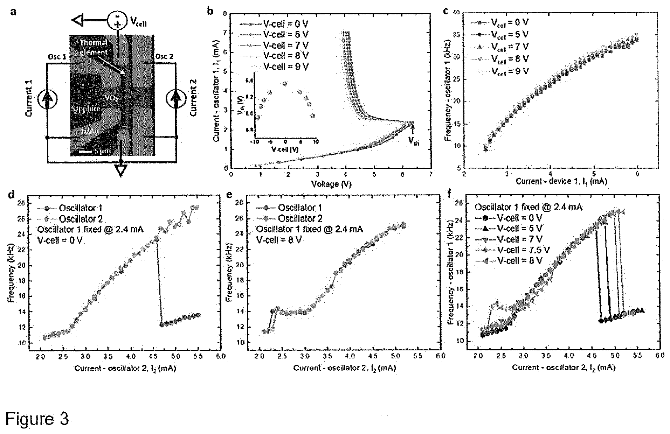

Fig. 3 shows the unable thermal coupling strength between two VO₂ oscillators.
   a: Optical microscope image of a set of two VO₂ oscillators with schematic illustrations. A 1.5 µm wide (21 µm long) VO₂ stripe is placed as a thermal heating element for enhancing the thermal coupling between two VO₂ oscillators with the dimension of 7×6 µm². The distance between oscillator 1 and oscillator 2 is 5 µm.
   b: I vs. V measurements (sweep current and measure voltage) of oscillator 1 under different thermal heating element voltage (V_{cell}). The threshold voltage (Vₜₕ) where the oscillator enters the negative differential resistance region reduces with increasing V_{cell}, as shown in the inset.
   c: I vs. f measurements (sweep current and measure frequency) from oscillator 1 under different V_{cell}. With higher V_{cell}, the oscillation frequency of oscillator 1 increases under a dc current.
   d: Frequency locking behavior at V_{cell} = 0 V. For this measurement, the current to oscillator 1 is fixed at 2.4 mA while increasing the current to oscillator 2. In this case, the frequency locking breaks above 23.5 kHz.
   e: Frequency locking behavior at V_{cell} = 8 V. In this case, the frequency locking breaks above 25.3 kHz.
   f: Comparison of synchronization frequency of oscillator 1 (fixed at 2.4 mA) under different thermal heating element voltage V_{cell} (from 0 to 8 V).

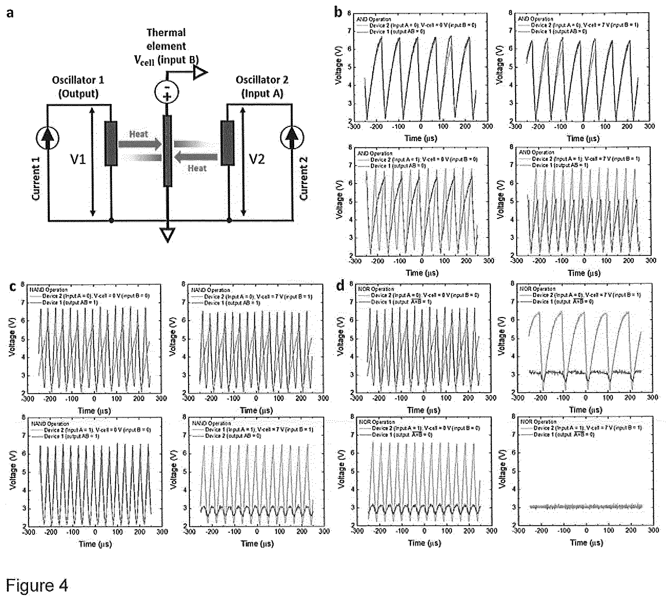

Fig. 4 shows Boolean logic gates based on thermally coupled VO₂ oscillators.
   a, Schematic illustration of logic operations realized by two VO₂ oscillators coupled by a thermal heating element. The oscillation status of oscillator 1 at different current, I₁, servers as input A and the thermal heating element voltage, V_{cell}, servers as input B, respectively. The oscillation status of oscillator 2 at a constant current I₂ are the read out (output). Examples of
   b: AND,
   c: NAND, and
   d: NOR operations.

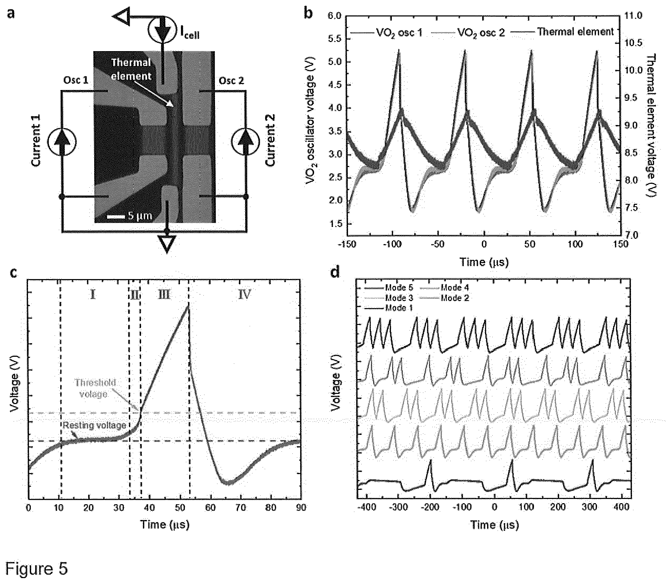

Fig. 5 shows thermal spike driven VO₂ oscillation with different firing modes.
   a: Optical image of test VO₂ oscillator set used for the generation of spiking potential. VO₂ oscillator 1, oscillator 2, and thermal heating element are excited by three independent current sources.
   b: The oscillation waveform when VO₂ oscillator 1 is excited at 3.9 mA, VO₂ oscillator 2 is excited at 4.0 mA, and thermal heating element is activated at 2.3 mA.
   c: The output waveform from VO₂ oscillator 2 that is generated by the cascade synchronization among three cells. This behavior mimics the generation of the spiking potential in a neuron when it is stimulated; Region-I: Resting state; Region-II: Stimulation arrives; Region-Ill: Depolarization state; Region-IV: Repolarization and hyperpolarization state (also known as refractory period) as discussed in [7, 34, 35].
   d: Different firing modes of the VO₂ neuron by simply changing the current of VO₂ oscillator 1 (I₁ from 1 mA to 5.2 mA), while keeping the current to VO₂ oscillator 2 (I₂ = 4 mA) and thermal heating element (I_{cell} = 2.3 mA) fixed.
Fig. 6 shows a 2 Oscillator 1 heating element structure
Fig. 7 shows a 4 Oscillator 1 heating element structure
Fig. 8 shows a side view of an array of embedded oxide oscillator / heating element cells formed in a cross-bar type.

### Detailed Description of the Invention

On the verge of the phase transition temperature, certain strongly correlated oxide materials - known as *correlated oxides* - show oscillation characteristics upon external stimulus (e.g., by current, magnetic field, electric field, etc.) [1, 2]. In such systems, one can observe the oscillation of the electronic state (e.g., low resistance in the metallic state and high resistance in the insulating state), which is considered to be the fundamental building element for an oscillatory network. Examples of such correlated oxides are e.g., Ta₂O₅₋ₓ (with x preferably between 0 and 1), NbO₂, or VO₂. Oscillators based on Vanadium dioxide (VO₂) are of particular interest since the material shows insulating to metallic phase transition near 340 K (insulating phase at room temperature) [3 - 6].

In order to develop an efficient oscillator-based computation network, mutual interactions (synchronization) and tunable coupling strength are two critical aspects for such systems. It is already well-known that VO₂ can show various oscillation characteristics and coupling effects when the VO₂ oscillators are connected to external electronic components such as resistors, capacitors or/and inductors [7 - 17]. However, these oscillators require additional electronic elements for generating oscillation features or tuning the coupling among VO₂ oscillators, which not only reduces the oscillator density but also greatly increases the complexity for the architecture of a fully functioning circuit. Other than oscillation coupling with external electronic complex circuits, there are reports showing that VO₂ oscillators can be thermally linked, using additional capacitors and resistors, and can be used for computation tasks with the subharmonic ratio of different VO₂ oscillators [18 - 20]. So far, computation based on phase relation (binary phase states 0° or 180° relative to the reference oscillator) between oscillators is the most common technique in coupled VO₂ networks [8 - 16], while fundamental Boolean (logic gate operations) and non-Boolean (analog) computation techniques have not yet been explored using the oscillation states based on frequency and amplitude.

Different from phase relation-based computation, richer coupling dynamics from the network system can lead to the computation technique based on both frequency domain and amplitude. This, in principle, can generate abundant synchronous oscillation states from the coupled oscillators, which - so far - still remains as a challenge in this area.

The present invention introduces a novel and effective approach to enable thermally coupled oscillators systems to have tunable synchronized frequency and different collective coupling behavior. To achieve this, an additional heating element, e.g. a metal wire, like an Fe-, Cu-, Co-, Ni-, W-, V- or a corresponding alloy-wire, or a nanowire made from the same material as the oscillator, like VO₂, (preferably with a diameter in the 1 to 3 digit nano-range), was implemented that acts as a thermal heating element that can actively change the ambient thermal condition between at least two correlated oxide oscillators. The resistance of the heating element is determined by its size and resistivity. For this purpose a material with a tunable resistivity may be preferred e.g. a nitride that is formed from e.g. Ti₁₋ₓNₓ or Ta₁₋ₓNₓ where x can be varied over a wide but is preferably in the range 0.45 to 0.55 or more preferably in the range 0.48 to 0.52. The resistivity can be tuned so as to optimize the current needed to energize the heater. For example, it may be preferably to have the resistance of the heater to be comparable to that of the oscillators themselves which depends on the respective size and shape and thickness of the respective devices. This allows for similar voltages to be applied to the heater and the oscillator elements making the system of oscillators and heaters more easily to be controlled. The resistivity of Ti₁₋ₓNₓ and Ta₁₋ₓNₓ can be varied widely with the highest resistivity for x~0.5.

In such a system, it was found that the oscillators can be effectively synchronized and triggered even at sub-threshold current range via controlling the thermal heating element. Different operation modes of the thermal heating element (V-mode / I-mode) enable rich and controllable coupling dynamics among oscillators in the system. Various oscillation states can be generated by these coupled oscillators to realize 12 different basic Boolean logic operations from AND, NAND and NOR gates in V-mode (thermal heating element). In addition, the thermal heating element can induce cascade synchronization among at least three coupled correlated oxide oscillators when operated in I-mode - which generates more complex forms of the oscillation states (like spiking and bursting patterns) that mimics the behavior of a biological neuron. Specifically in this case it is preferred to use a VO₂ nanowire.

Accordingly, the present invention, relates to a thermally coupled correlated oxide oscillator system comprising at least two correlated oxide oscillators coupled via at least one heating element, which is inter-positioned between at least two of the at least two correlated oxide oscillators.

The invention further comprises a logic device comprising a multiplicity of coupled correlated oxide oscillator(s) / heating element(s) cells, wherein each cell has a dimension of 1-heat-n-oscillators, with n= 1, 2, 3, 4, 5, 6, 7, 8; preferably n= 2, 3, 4, 5, 6, 7, 8, more preferred n= 2, 3, 4. In principle, the number of coupled oscillators can be extended as long as the heat range reaches.

The correlated oxide oscillators can be manufactured using known deposition and lithography techniques. Using this technique first a film of the correlated oxide material is deposited on a substrate, e.g. a sapphire substrate like c-plane sapphire [0001]. Conventional pulsed laser deposition can be used for this deposition. Typical thicknesses for this deposition of the correlated oxide oscillators range from 10 to 100 nm, preferably 20 to 50 nm, more preferred 25 to 40 nm. The prepared thin films are then patterned to oscillator devices by conventional optical lithography technology as shown e.g. in Figures 2b, 2c, 3a or 4a. If the material of the heating element is identical to the one of the correlated oxide materials used for the oscillators, the complete oscillators/heating elements pattern can be shaped in one step. If the material of the heating element is different from the one of the correlated oxide materials used for the oscillators, they can be shaped individually in subsequent lithography pattern steps; e.g. by first forming VO₂ oscillators, then forming heat elements and at last forming the electrical contacts. The shape of the correlated oxide oscillators is not critical but is typically square shaped or rectangular with sizes from 0.0001 to 1000 µm², preferably 0.005 to 50 µm², more preferred 0.005 to 10 µm². Likewise, the shape of the heating elements is not critical but is typically square shaped or rectangular, preferably rectangular with sizes from 0.0001 to 1000 µm², preferably 0.005 to 50 µm², more preferred 0.005 to 10 µm².

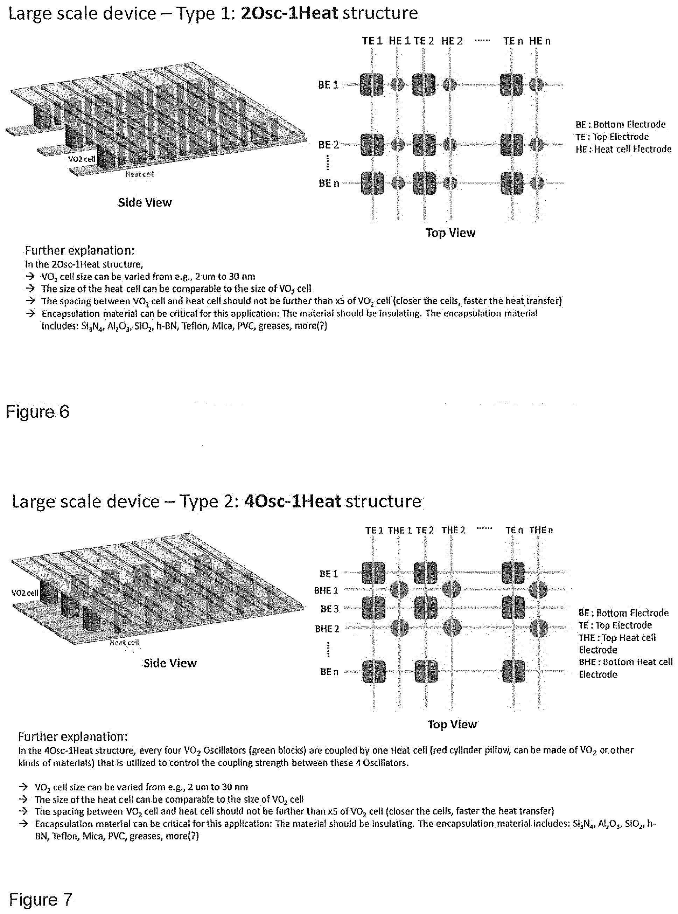

The spacing (center-to-center) between the correlated oxide oscillator(s) and the heat element(s) is preferably not larger than 5 times, preferably 2 times and more preferred 1.5-1.9 times the width (which is preferably from 10 nm to about 30000 nm) of a single correlated oxide oscillator. Typical thicknesses for heat elements range from 10 to 100 nm, preferably 20 to 50 nm, more preferred 25 to 40 nm. In a logic device comprising a multiplicity (i.e. more than two) of coupled correlated oxide oscillator / heating element cells, i.e. an array of cells, the spacing between all individual correlated oxide oscillators and all heating elements is preferably equidistant in the plane of the multiplicity of coupled correlated oxide oscillator / heating element cells. An array of oxide oscillator / heating element cells can e.g. be formed in a cross-bar type (see Fig. 6, 7 and 8). For example, the array can be formed as (1) 2Osc-1Heat element. In this case 1 heating element is placed between 2 oscillators. Another example is (2) a nOsc-1Heat element. In this case 1 heating element is placed at the center of n number of oscillators. An example of a 4Osc-1Heat element array is shown in Fig. 7. The size of an array depends on the number of coupled oscillators- the dimension of each coupled cells (spacing, diameter, thickness of cells) are as described above.

The heater elements, especially if formed from a different materials class from the nano-oscillators, may be deposed in a layer above or below the oscillators both for ease of fabrication and for more effective coupling to 2 or more oscillators.

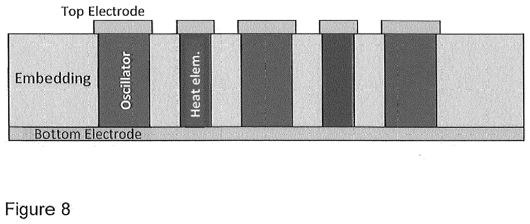

In a preferred embodiment of an array of oscillators/heating element cells the oscillators as well as the heating elements are embedded in an electrically insulating but thermally conductive material as shown in Figure 8. The embedding material can be critical for this application, specifically when it is decisive to distinguish between thermal heating and electrical conduction, i.e. to allow for better thermal conduction while blocking electrical connection between cells. Preferred embedding materials can e.g. be selected from one or more of: Si₃N₄, Al₂O₃, SiOz, h-BN (hexaboron-nitride), Teflon, Mica, PVC, thermal greases (e.g. silicon grease).

The required electrodes can be placed e.g. by using conventional lift-off methods, e.g. ion beam deposition. Typical materials for the electrodes are metals or alloys, e.g. Ti/Au. The thicknesses of the electrodes typically range from 10 to 1000 nm, preferably 50 to 100 nm.

### Definition of terms

The below definition of terms applies to the terms used in singular as well as in plural form:
"Coupled" and/or "Thermally coupled" means that at least two oscillators (or cells) are placed within a range in which one oscillator's input can affect the other oscillator(s)' output via Joule heating.

"Correlated oxide" is an oxide showing electronic phase transition between insulator and metal. Examples of correlated oxides, which can be used in the present invention are Ta₂O₅₋ₓ (with x preferably being between 0 and 1), NbO₂, or VO₂, preferably VO₂.

"Oscillator" is a system that shows oscillating phase transition between metallic and insulating states via injection of current or voltage

"Heating element" or "thermal element" is an element that can generate heat/thermal energy by Joule heating.

"Multiplicity of coupled correlated oxide oscillator / heating elements" means an aggregate of coupled correlated oxide oscillator / heating elements, which are arranged next to each other.

"I-mode" is a type of operation method that uses current to operate the cells.

"V-mode" is a type of operation method that uses voltage to operate the cells.

"Logic device" means a digital device that generates an output of 1 or 0 by the combination of two inputs.

For a single set of two correlated oxide oscillators (two oscillators driven by two independent current sources; no thermal element in-between), the further the oscillators are separated, the weaker the thermal link will be. When two oscillators are separated far apart, the heat released from one oscillator will dissipate entirely into the substrate before reaching the other oscillator. Besides, the coupling strength between two oscillators has its limitation, and can only hold the synchronization to a certain frequency range. In order to realize a tunable thermal coupling strength, a thermal heating element, preferably a VO₂ thermal element is placed in the middle of two correlated oxide oscillators, as demonstrated in Fig. 3a. This thermal heating element is designed to change the ambient thermal environment between oscillator 1 and oscillator 2. By applying different heating element voltage V_{cell} that induces Joule heating, the ambient temperature between oscillator 1 and oscillator 2 can be changed. Higher heating element voltage V_{cell} can create higher ambient temperature, which will lead to a lowering of the threshold switching voltage (as shown in Fig. 3b) and higher oscillation frequency (under the same applied current, as demonstrated in Fig. 3c). This is because the starting point of the oscillation circle (phase transition from high resistive state to low resistive state and then back to high resistive state) in the R-T hysteresis loop has been biased to higher temperature that is closer to T_{c}. Therefore, with enhanced thermal coupling strength (higher V_{cell}), oscillator 1 can be assisted to lock to the higher frequency of oscillator 2. In the case when the thermal heating element is not activated (V_{cell} = 0 V), as shown in Fig. 3d, oscillator 1 was supplied with constant low current I₁ (2.4 mA) and oscillates at low frequency. By gradually increasing the supply current I₂ for oscillator 2, the frequency of oscillator 1 (f₁) and the frequency of oscillator 2 (f₂) are synchronized until 23.5 kHz. When f₂ is further increased, due to limited thermal coupling strength, f₁ first drops to the value that is about one half of f₂ and then increases slowly while maintaining a ratio of roughly 1:2 (f₁: f₂) to f₂. In the case when the thermal heating element is activated (as shown in Fig. 3e when V_{cell} = 8 V), with very strong thermal coupling strength, f₁ can now be fully locked to the frequency f₂ until 25.3 kHz. Besides, the synchronization frequency has a sharp increase (from about 11 kHz to 14 kHz) already at lower current value I₂ (at around 2.2 mA). The significant difference between the synchronization behavior of oscillator 1 under weak/moderate (V_{cell} < 8 V) and strong (V_{cell} = 8 V) coupling effect can be observed from Fig. 3f.

### Realization of Boolean logic gate operations based on coupled oscillators

Based on the above discussed tunable thermal coupling mechanism, three different Boolean logic gates (AND, NAND and NOR) are realized by the device set shown in Fig. 3a. The oscillation state of an oscillator, which is represented by the oscillation frequency (f) and amplitude (A), is taken as logic "0" or "1". The threshold frequency fₜₕ is defined as the frequency where oscillator1 and oscillator 2 desynchronize at V_{cell} = 0 V when I₁ is fixed at 2.5 mA while I₂ is gradually increasing (fₜₕ = 23.5 kHz is taken for the following computation). A frequency lower than fₜₕ is defined as "low frequency", while a frequency higher than fₜₕ is defined as "high frequency". Peak-to-peak value Vₚₖ₋ₚₖ = 1 V is chosen as threshold amplitude. An amplitude smaller than Vₚₖ₋ₚₖ is defined as "small amplitude", while an amplitude larger than Vₚₖ₋ₚₖ is defined as "large amplitude".

Basically, there are 4 types of oscillation states: high frequency with large amplitude, high frequency with small amplitude, low frequency with large amplitude and low frequency with low amplitude. Here, only the oscillation state with high frequency and large amplitude is taken as logic "1". The other states are taken as logic "0".

As shown in Fig. 4a, the oscillation states of oscillator 1 under different given current value (I₂) is taken as input A, while the thermal heating element voltage V_{cell} value represents input B (V_{cell} = 0 V stands for B = 0, V_{cell} = 7 V stands for B = 1). The current value of oscillator 1 (I₁) is kept constant during each operation, while the oscillation state of oscillator 1 under input A and input B is taken as output.

For AND operation, I₁ is fixed at 2.5 mA, while I₂ = 5 mA is taken as input logic "1", and I₂ = 2.5 mA is taken as input logic "0". For NAND operation, I₁ is fixed at 6.2 mA, while I₂ = 5 mA is taken as input logic "1", and I₂ = 2.4 mA is taken as input logic "0". For NOR operation, I₁ is fixed at 6.4 mA, while I₂ = 5.2 mA is taken as input logic "1", and I₂ = 2.5 mA is taken as input logic "0". As demonstrated in the plots, the output logic "0" from oscillator 2 (marked as red curve) can be represented by 4 different oscillation states:
low frequency with large amplitude (Fig. 4b); or high frequency with small amplitude (Fig. 4c); or low frequency with small amplitude / no oscillation (Fig. 4d).

### Control of firing modes in coupled oscillators

Different from operating the thermal heating element in V-mode, applying a constant current (I_{cell}), i.e., I-mode, to the thermal heating element can form cascade synchronization among the correlated oxide oscillators and the thermal heating element. In this case the thermal heating element itself has to be an oscillator itself; i.e. it is preferably made from a correlated oxide, e.g. VO₂. This phenomenon occurs because the thermal heating element is now also oscillating (with I_{cell} within the NDR region), and the heat periodically released from it strongly links the oscillation of oscillator 1 and oscillator 2 to its own period. As shown in Fig. 5a, oscillator 1 (cell 1), oscillator 2 (cell 2), and thermal heating element (thermal cell) are excited with three independent current sources. With I₁ = 4 mA, I₂ = 3.9 mA and I_{cell} = 2.3 mA, frequency locking among the three devices can be observed in Fig. 5b.

Conceptually, the output waveform of oscillator 2 is similar to the spiking potential of a neuron when it is stimulated. In biological systems, neurons possess abundant and complex response, the external stimuli. Based on different responses in neurons, various spiking neuron models have been established, such as tonic spiking and bursting, phase spiking and bursting, etc. [31].

As demonstrated in Fig. 5c, four typical regions can be identified when a neuron transforms from resting state to excited state [7, 32 - 34]: Region-I corresponds to the resting state when the neuron is not excited and its potential remains at the resting voltage level. Region-II is when the stimulation arrives and triggers the neuron potential to rise. Region-III corresponds to the depolarization state where the potential exceeds the threshold and releases a spike. Region-IV is the repolarization and hyperpolarization state (also known as refractory period) where the potential recovers back to the resting state. By simply adjusting the current of oscillator 1 (between 1 mA and 5.2 mA) while keeping the current of oscillator 2 and the thermal heating element constant (I₂ = 4 mA, I_{cell} = 2.3 mA), different numbers of spikes (5 different neuron firing modes) can be generated within one firing period from oscillator 2, as shown in Fig. 5d. Among these 5 firing modes, mode 2 can be considered as the tonic spiking neuron that fires one spike within one period, while mode 3 and 5 can be classified as the tonic bursting neuron that fires bursts of multiple spikes periodically [31, 35 - 39].

### Discussion and Outlook

This invention experimentally demonstrated and explained the tunable thermal coupling effect between two closely correlated oxide oscillators without external electronic components like resistor, capacitor or inductor [9 - 16] - as previously discussed. By changing the voltage applied on the thermal heating element in the middle of two oscillators, the thermal coupling strength can be enhanced and the range of synchronization frequency can be effectively enlarged. Based on different oscillation states generated from the coupled oscillators, Boolean type computation via setting thresholds in frequency and amplitude has been introduced. The application of these synchronized oscillators with tunable thermal coupling strength for AND, NAND and NOR logic gates have been demonstrated.

The heating element may also provide a tunable thermal coupling between more than 2 oscillator elements. For example, the heater element may couple 3, 4 or more oscillators by placing the element at the nexus of 3, 4 or more oscillators. It may also be preferable to provide for asymmetric tunable thermal coupling by placing the element at different distances from the elements that are coupled.

This thermally assisted frequency synchronization process can also be considered similar to the signal propagation in a neural system. Action potential incorporated with information modulated in frequency (or amplitude, or both) propagates from presynaptic neuron to post-synaptic neuron through synapse [40 - 44]. During this process, action potential is transmitted through the synaptic gap via releasing neurotransmitter from the axon of the previous neuron to the dendrite of the next neuron [45]. Oscillator 1 (cell 1) in Fig. 4a acts as pre-synaptic neuron while oscillator 2 (cell 2) acts as post-synaptic neuron, respectively. These two neurons communicate via oscillating potential, similar to neurons in a biological system. The thermal heating element is equivalent to the synapse. Post-synaptic neuron (oscillator 2) is supplied with constant low current and thus will only output low frequency signal when it is not synchronized to the pre-synaptic neuron (oscillator 1). Information is encoded in the domain above the threshold frequency where oscillator 1 and oscillator 2 desynchronize at V_{cell} = 0 V, and is fed into the presynaptic neuron (oscillator 1) as continuously varying current (frequency-modulated). At V_{cell} = 0 V, there is no synchronization between neurons in the frequency range where information is encoded.

As a result, all information encoded in modulated frequency from the pre-synaptic neuron (oscillator 1) is lost while propagating to the post-synaptic neuron (oscillator 2). With V_{cell} ≠ 0 V, meaning that a neural link has been established and two neurons are synchronized, the information encoded in the frequency can be transmitted to the post-synaptic neuron. Such mechanism can be also applied for frequency modulated data transmission in an analog network [46, 47] for non-Boolean operations.

Furthermore, cascade synchronization among three oscillators was demonstrated. By simply changing the current supplied to one of the coupled correlated oxide oscillators, 5 different firing modes like spiking and bursting can be generated from one of the coupled oscillators. Such current-driven firing behavior can be used for coding an artificial spiking neural network, in which the output spikes (numbers and firing time) depend on the intensity and spatiotemporal distribution of the input signal [48].

Thermally coupled oscillator sets that can generate multiple synchronous states are inherently suitable for building oscillatory computational networks that require dynamic richness and tuneability. Such technique is demanded for solving different types of computationally hard problems such as image processing, combinatorial problems and so on [49 - 54].

### Experimental details

### Sample and device preparation

V42 films with thickness of about 30 nm (determined by XRR measurement) were deposited on c-plane sapphire [0001] substrate by PLD (pulsed laser deposition) technique. A KrF excimer laser (Coherent LPX pro) beam with a frequency of 3 Hz was focused onto the VO2 target (99.9 % purity, Plasmaterials) in a chamber under ambient O2 of 0.020 mbar at 450°C. Energy and fluence of the laser beam on the target surface were 44 mJ and 587 mJ/cm2, respectively. After deposition the sample is cooled down under ambient O2 of 0.045 mbar. Then the prepared thin films were patterned to devices by conventional optical lithography technology. Negative tone of photoresist (ARN-4340, Allresist) and maskless aligner (Heidelberg MLA 150) were used. Then, lift-off method is used to place the electrodes. For the contacts, about 77 nm Ti/Au were deposited via ion beam deposition.

### Electrical transport measurement

For the temperature dependent resistance measurement, we used physics property measurement system (PPMS) with conventional 4-points resistance measurement scheme with cooling and warming rate of 5 K/min. For the 4-points measurement, 1 µA dc current (Keithley 6221 acldc source and 2182a nanovoltmeter set) was applied to the sample to minimize the effect of Joule heating.

For the oscillation state measurement with various types of devices, we performed the measurements in multi-probe cryogenic probe station (Lakeshore). Current source (Keithely 6221 ac/dc current source) and source meter (Keithely 2636B) were used to drive the oscillators and thermal heating element, the oscillating voltage was collected by an oscilloscope (DSO5052A, InfiniiVision) with home-built LV codes.

### References

[1] Asmara, T., Wan, D., Zhao, Y. et al. Tunable and low-loss correlated plasmons in Mott-like insulating oxides. Nat Commun 8, 15271 (2017).
[2] Gao, L., Chen, P. and Yu, S. NbOx based oscillation neuron for neuromorphic computing. Appl. Phys. Lett. 4, 103503 (2017).
[3] McGee, R. et al. Sharpness and intensity modulation of the metal-insulator transition in ultrathin VO2 films by interfacial structure manipulation. Phys. Rev. Mat. 2, 034605 (2018).
[4] Yang, T. et al. On growth of epitaxial vanadium oxide thin film on sapphire (0001). J. Mater. Res. 25, 422-426 (2010).
[5] Hattori, A. N. et al. Investigation of Statistical Metal-Insulator Transition Properties of Electronic Domains in Spatially Confined VO2 Nanostructure. Crystals 10, 631 (2020).
[6] Jeong, J. et al. Suppression of Metal-Insulator Transition in VO2 by Electric Field-Induced Oxygen Vacancy Formation. Science 339, 1402-1405 (2013).
[7] Yi, W. et al. Biological plausibility and stochasticity in scalable VO2 active memristor neurons. Nat. Commun. 9, 4661 (2018).
[8] Shukla, N., et al. Pairwise coupled hybrid vanadium dioxide-MOSFET (HVFET) oscillators for non-boolean associative computing. IEDM 2014, San Francisco, CA, USA (2014).
[9] Corti, E., Gotsmann, B., Moselund, K., Stolichnov, I., lonescu, A. and Karg, S. Resistive Coupled VO2 Oscillators for Image Recognition. ICRC, McLean, VA, USA (2018).
[10] Corti, E., Gotsmann, B., Moselund, K., Stolichnov, I., lonescu, A. and Karg, S., Robertson, J. Scaled resistively-coupled VO2 oscillators for neuromorphic computing. Solid State Electron. Lett. 168, 107729 (2020).
[11] Corti, E., Gotsmann, B., Moselund, K., Stolichnov, I., Karg, S., Robertson, J. Time-Delay Encoded Image Recognition in a Network of Resistively Coupled VO2 on Si Oscillators. IEEE Electron Device Lett. 41, 629-632 (2020).
[12] Corti, E. et al. Coupled VO2 Oscillators Circuit as Analog First Layer Filter in Convolutional Neural Networks. Front. Neurosci. 15, 628254 (2021).
[13] Carapezzi, S. et al. Multi-Scale Modeling and Simulation Flow for Oscillatory Neural Networks for Edge Computing. 2021 NEWCAS, Toulon, France (2021).
[14] Todri-Sanial, A. et al. How Frequency injection Locking Can Train Oscillatory Neural Networks to Compute in Phase. IEEE Trans Neural Netw Learn Syst. 33, 1996-2009 (2022).
[15] Delacour, C. et al. Oscillatory Neural Networks for Edge AI Computing. ISVLSI, Tampa, FL, USA (2021).
[16] Núñez, J. et al. Oscillatory Neural Networks Using VO2 Based Phase Encoded Logic. Front. Neurosci. 15, 655823 (2021).
[17] Lee, Y. et al. Metal-insulator transition-induced electrical oscillation in vanadium dioxide thin film. Appl. Phys. Lett. 92, 162903 (2008).
[18] Velichko, A., Belyaev, M., Putrolaynen, V., Perminov, V. and Pergament, A. Modeling of thermal coupling in VO2-based oscillatory neural networks. Solid State Electron. Lett. 139, 8 (2018).
[19] Velichko, A., Belyaev, M. and Boriskov, P. A Model of an Oscillatory Neural Network with Multilevel Neurons for Pattern Recognition and Computing. Electronics 8, 75 (2019).
[20] Velichko, A., Belyaev, M., Putrolaynen, V., Perminov, V. and Pergament, A. Thermal coupling and effect of subharmonic synchronization in a system of two VO2 based oscillators. Solid-State Electron. 141, 40-49 (2018).
[31] Izhikevich, E. M. Which model to use for cortical spiking neurons. IEEE Trans. Neural Netw. 15, 1063-1070 (2004).
[32] Corson, N., Aziz-Alaoui, M. Asymptotic dynamics of Hindmarsh-Rose neuronal system. Dynamics of Continuous, Discrete and Impulsive Systems Series B: Applications and Algorithms 16, 535 (2009).
[33] Hille, B. Ionic channels of excitable membranes, Sinauer associates Inc. (1992).
[34] Gerstner, W., Kistler, W. M., Naud, R. and Paninski, L. Neuronal Dynamics: From Single Neurons to Networks and Models of Cognition. Cambridge University Press (2014).
[35] Agmon, A. and Connors, B. Repetitive burst-firing neurons in the deep layers of mouse somatosensory cortex. Neurosci. Lett. 99, 137-141 (1989).
[36] McCormick, D. A., Connors, B. W., Lighthall, J. W. and Prince, D. A. Comparative electrophysiology of pyramidal and sparsely spiny stellate neurons of the neocortex. J. Neurophysiol. 54, 782-806 (1985).
[37] Gibson, J. R., Beierlein, M. and Connors, B. W. Two networks of electrically coupled inhibitory neurons in neocortex. Nature. 402, 75 (1999).
[38] Gray, C. M. and McCormick, D. A. Chattering cells: superficial pyramidal neurons contributing to the generation of synchronous oscillations in the visual cortex. Science. 274, 109-113 (1996).
[39] Brumberg, J. C., Nowak, L. G. and McCormick, D. A. Ionic mechanisms underlying repetitive high-frequency burst firing in supragranular cortical neurons. J. Neurosci. 20, 4829-4843 (2000).
[40] Wyffels, F., Li, J., Waegeman, T. et al. Frequency modulation of large oscillatory neural networks. Biol Cybern. 108, 145-157 (2014).
[41] Wyffels, F. and Schrauwen, B. Design of a Central Pattern Generator Using Reservoir Computing for Learning Human Motion. 2009 Advanced Technologies for Enhanced Quality of Life, Iasi, Romania (2009).
[42] Soman, K., Muralidharan, V. and Chakravarthy, V. S. An Oscillatory Neural Autoencoder Based on Frequency Modulation and Multiplexing. Front. Comput. Neurosci. 12, 00052 (2018).
[43] D. Cumin, and C. P. Unsworth, "Generalising the Kuramoto model for the study of neuronal synchronisation in the brain", Phys. D Nonlin. Phenomena 226, 181-196 (2006).
[44] Hoppensteadt, F. C. and Izhikevich, E. M. Thalamo-cortical interactions modeled by weakly connected oscillators: could the brain use FM radio principles. BioSystems. 48, 85-94 (1998).
[45] Faber, D. S. and Pereda, A. E. Two Forms of Electrical Transmission Between Neurons. Front. Mol. Neurosci. 11, 00427 (2018).
[46] Guy, C.G. Analog Data Transmission. Data Communications for Engineers. Macmillan New Electronics Series. Palgrave, London (1992).
[47] Smith, D.R. Digital Transmission Over Analog Networks. Digital Transmission Systems. Springer, Boston (2004).
[48] Yu, Q., Tang, H., Hu, J., Tan, K.C. Rapid feedforward computation by temporal encoding and learning with spiking neurons. Neuromorphic Cognitive Systems, 19-41. Springer, Berlin (2017).
[49] Csaba, G., Porod, W. Coupled oscillators for computing: A review and perspective. Appl. Phys. Rev. 7, 011302 (2020).
[50] Heger, D. and Krischer, K. Robust autoassociative memory with coupled networks of Kuramoto-type oscillators. Phys. Rev. E. 94(2), 022309 (2016).
[51] Vodenicarevic, D., Locatelli, N., Grollier, J. and Querlioz, D. Synchronization detection in networks of coupled oscillators for pattern recognition. IJCNN, Vancouver, BC, Canada (2016).
[52] Smith, K. A. Neural networks for combinatorial optimization: A review of more than a decade of research. Informs J. Comput. 11(1), 15-34 (1999).
[53] Wu, C. W. Graph coloring via synchronization of coupled oscillators. IEEE Trans. Circuits Syst. I. 45(9), 974-978 (1998).
[54] Wu, J., Jiao, L., Li, R. and Chen, W. Clustering dynamics of nonlinear oscillator network: Application to graph coloring problem. Physica D 240(24), 1972-1978 (2011).

## Claims

1. Thermally coupled correlated oxide oscillator system comprising at least two correlated oxide oscillators coupled via at least one heating element, which is inter-positioned between at least two of the at least two correlated oxide oscillators.

2. Thermally coupled correlated oxide oscillator system according to claim 1, wherein the correlated oxide is selected from one or more of Ta₂O₅₋ₓ, NbO₂, or VO₂.

3. Thermally coupled correlated oxide oscillator system according to claim 1 or 2, wherein the heating element is made of Fe, Cu, Co, Ni, W, V or an alloy of two or more of these metals.

4. Thermally coupled correlated oxide oscillator system according to claim 1 or 2, wherein the heating element is made of a nitride of the composition Ti₁₋ₓNₓ or Ta₁₋ₓNₓ.

5. Thermally coupled correlated oxide oscillator system according to claim 1 or 2, wherein the heating element is made of VO₂.

6. Thermally coupled correlated oxide oscillator system according to one of claims 3 to 5, wherein the heating element is a wire.

7. Thermally coupled correlated oxide oscillator system according to claim 6, wherein the heating element is a nano-wire.

8. Thermally coupled correlated oxide oscillator system according to one of claims 1 to 7, wherein the correlated oxide has a thickness from 10 to 100 nm.

9. Thermally coupled correlated oxide oscillator system according to one of claims 1 to 8, wherein the shape of the correlated oxide oscillator is square shaped or rectangular.

10. Thermally coupled correlated oxide oscillator system according to claim 9, wherein the size of the correlated oxide oscillator is from 0.0001 to 1000 µm².

11. Thermally coupled correlated oxide oscillator system according to one of claims 1 to 10, wherein the center-to-center spacing between the correlated oxide oscillators and the heat element or heating elements is not larger than 5 times the width of a single correlated oxide oscillator.

12. Method of manufacturing a thermally coupled correlated oxide oscillator system according to claim 1, the method comprising the steps of depositing a film of the correlated oxide material on a substrate,
- patterning the oscillator/heating element pattern by optical lithography technology if the material of the heating element is identical to the one of the correlated oxide material used for the oscillators, or
- individually patterning the oscillator and heating element pattern in subsequent lithography pattern steps if the material of the heating element is different from the one of the correlated oxide materials used for the oscillators
then forming heat elements and at last the electrical contacts.

13. Logic device comprising a multiplicity of thermally coupled correlated oxide oscillator systems according claim 1.

14. Logic device according to claim 13, wherein the multiplicity of thermally coupled correlated oxide oscillator systems form cells and each cell has a dimension of 1-heat-n-oscillators, with n= 1, 2, 3, 4, 5, 6, 7 or 8.

15. Neural network comprising a multiplicity of thermally coupled correlated oxide oscillator systems according claim 1.
